(19) **Europäisches Patentamt**

**European Patent Office**

**Office européen des brevets**

(11) Veröffentlichungsnummer: **0 225 587 B1**

(12) # EUROPÄISCHE PATENTSCHRIFT

(45) Veröffentlichungstag der Patentschrift: **24.02.93**

(21) Anmeldenummer: **86116757.5**

(22) Anmeldetag: **02.12.86**

(51) Int. Cl.⁵: **H03K 5/01**, H03K 5/135, H04L 25/20

(54) **Schaltungsanordnung zum Regenerieren und Synchronisieren eines digitalen Signales.**

(30) Priorität: **07.12.85 DE 3543392**

(43) Veröffentlichungstag der Anmeldung:
**16.06.87 Patentblatt 87/25**

(45) Bekanntmachung des Hinweises auf die
Patenterteilung:
**24.02.93 Patentblatt 93/08**

(84) Benannte Vertragsstaaten:
**BE DE FR IT NL**

(56) Entgegenhaltungen:
**DE-A- 3 441 501**

(73) Patentinhaber: **Alcatel SEL Aktiengesellschaft**
**Lorenzstrasse 10**
**W-7000 Stuttgart 40(DE)**

(84) Benannte Vertragsstaaten:
**DE**

(73) Patentinhaber: **ALCATEL N.V.**
**Strawinskylaan 537 (World Trade Center)**
**NL-1077 XX Amsterdam(NL)**

(84) Benannte Vertragsstaaten:
**BE FR IT NL**

(72) Erfinder: **Klein, Michael, Dr.**

Grabenstrasse 39
W-8501 Rückersdorf(DE)
Erfinder: **Wölk, Joachim**
Neckarsblick 59
W-7122 Besigheim(DE)
Erfinder: **Liu, Shao Han**
29 Melbourne Road
Norwalk Connecticut 06851(US)

(74) Vertreter: **Villinger, Bernhard, Dipl.-Ing. et al**
**Alcatel SEL AG Patent- und Lizenzwesen**
**Postfach 30 09 29**
**W-7000 Stuttgart 30 (DE)**

EP 0 225 587 B1

**Beschreibung**

Die Erfindung betrifft eine Schaltungsanordnung nach dem Oberbegriff des Patentanspruchs 1.

In der nicht vorveröffentlichten deutschen Patentanmeldung DE-A-34 41 501 ist der Schutz beansprucht für eine Schaltungsanordnung zum Regenerieren und Synchronisieren eines digitalen Signales hoher Bitrate, die eine Reihenschaltung aus einer steuerbaren Verzögerungsleitung und einer Entscheidungslogik aufweist, welche von dem digitalen Signal durchlaufen wird, wobei die Entscheidungslogik über eine erste Steuerleitung und eine zweite Steuerleitung und die steuerbare Verzögerungsleitung über Adressenleitungen an eine Verzögerungsregeleinheit angeschlossen sind, wobei die Entscheidungslogik über eine Taktleitung mit einem Systemtakt versorgt wird, dessen Frequenz der Bitrate des zu regenerierenden digitalen Signales entspricht und wobei die Verzögerungsregeleinheit einen voreinstellbaren Eingang zum Setzen eines vorgebbaren Zustandes aufweist.

Die technische Aufgabe der Erfindung besteht darin, eine sichere Regeneration und Synchronisation eines digitalen Signales zu realisieren.

Diese Aufgabe wird erfindungsgemäß durch die im Patentanspruch 1 angegebene technische Lehre gelöst.

Weitere vorteilhafte Ausbildungen des Gegenstandes der Erfindung sind den abhängigen Ansprüchen zu entnehmen.

Ein Ausführungsbeispiel wird im folgenden anhand der Zeichnungen ausführlich erläutert. Es zeigen:

Figur 1     ein detailiertes Blockschaltbild der erfindungsgemäßen Schaltungsanordnung,

Figur 2     eine Abtastschaltung der erfindungsgemäßen Schaltungsanordnung nach Figur 1,

Figur 3     eine steuerbare Verzögerungsleitung der erfindungsgemäßen Schaltungsanordnung nach Figur 1,

Figur 4     ein Zustandsdiagramm zur Erläuterung des Entscheiders der Entscheidungslogik der erfindungsgemäßen Schaltungsanordnung nach Figur 1 und

Figur 5     ein Zeitdiagramm zur Erläuterung der erfindungsgemäßen Schaltungsanordnung nach Figur 1.

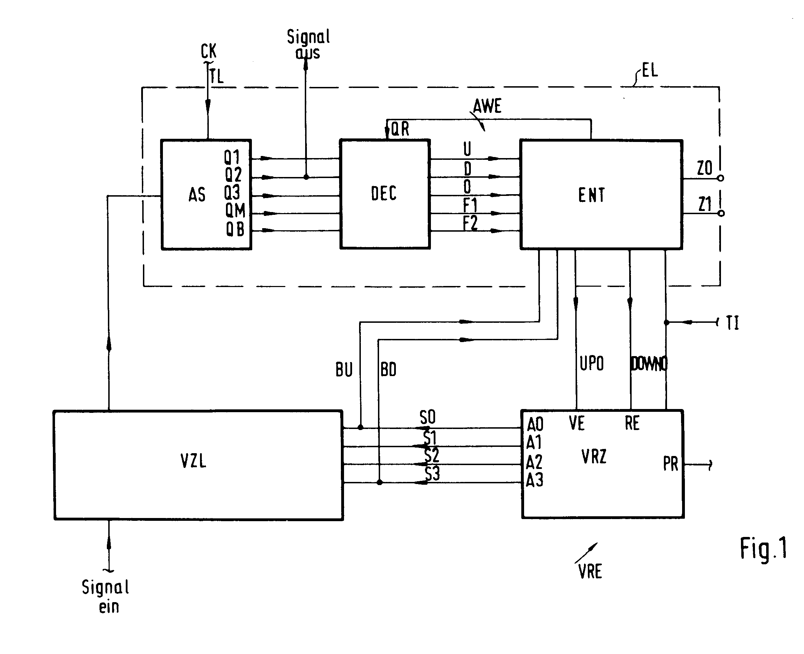

Zum sicheren Regenerieren und Synchronisieren eines digitalen Signales hoher Bitrate weist die erfindungsgemäße Schaltungsanordnung, wie in Figur 1 dargestellt, eine Reihenschaltung aus einer steuerbaren Verzögerungsleitung VZL und einer Entscheidungslogik EL auf. Die Entscheidungslogik EL ist über eine erste Steuerleitung UPO und eine zweite Steuerleitung DOWNO und die steuerbare Verzögerungsleitung VZL über Adressenleitungen S0, S1, S2, S3 an eine Verzögerungsregeleinheit VRE angeschlossen. Dabei enthält die Verzögerungsregeleinheit VRE einen voreinstellbaren Eingang PR, über den sie auf vorgebbare Zustände gesetzt werden kann.

Die Entscheidungslogik EL weist eine an eine Taktleitung TL angeschlossene Abtastschaltung AS und eine Auswerteeinheit AWE auf.

Über die Taktleitung TL wird die Abtastschaltung mit einem Systemtakt CK versorgt, dessen Frequenz der Bitrate des zu regenerierenden und synchronisierenden digitalen Signales entspricht.

Im vorliegenden Ausführungsbeispiel beträgt die Frequenz des Systemtaktes CK 139,264 MHz.

Die Auswerteeinheit AWE besteht aus einer Dekodiereinheit DEC und einem Entscheider ENT die untereinander über fünf Zustandsleitungen U, D, O, F1, F2 verbunden sind. Weiterhin weist der Entscheider ENT der Auswerteeinheit AWE einen ersten Zustandsanzeigeausgang Z0 und einen zweiten Zustandsanzeigeausgang Z1 auf und ist über eine erste Leitung BU und eine zweite Leitung BD an die steuerbare Verzögerungsleitung VZL angeschlossen.

Ferner ist der Entscheider ENT über die erste UPO und die zweite Steuerleitung DOWNO an einen Eingang VE für die Vorwärtszählrichtung bzw. an einen Eingang RE für die Rückwärtszählrichtung eines Vorwärts-Rückwärts-Zählers VRZ der Verzögerungsregeleinheit VRE angeschlossen. Der Entscheider ENT und der Vorwärts-Rückwärts-Zähler VRZ werden dabei mit einem internen Takt TI versorgt, der aus dem Systemtakt CK abgeleitet wird.

Hier ist die Frequenz des internen Taktes TI 1/8-mal so groß, wie die Frequenz des Systemtaktes CK.

Ausgänge A0, A1, A2, A3 des Vorwärts-Rückwärts-Zählers VRZ sind über die Adressenleitungen S0, S1, S2, S3 mit der steuerbaren Verzögerungsleitung VZL verbunden.

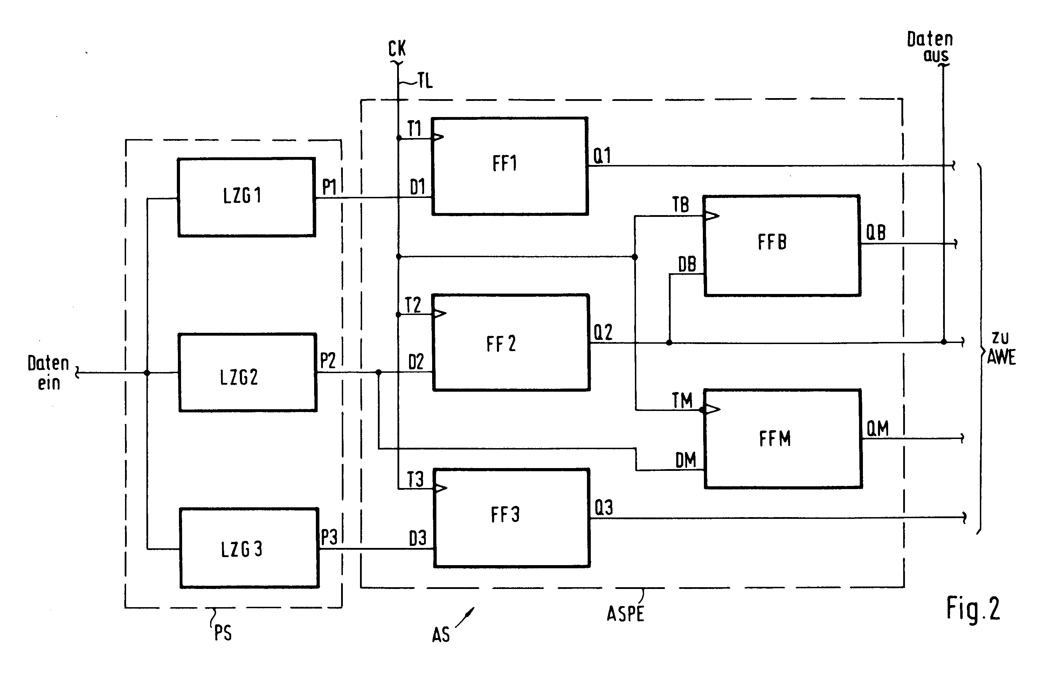

Die Abtastschaltung AS, wie in Figur 2 gezeigt, besteht aus einem dreistufigen Phasenschieber PS und einer aus fünf Zwischenspeicher FF1, FF2, FF3, FFM, FFB aufgebauten Abtast/Speichereinheit ASPE.

Dabei ist ein Ausgang P1 der ersten Stufe des Phasenschiebers PS mit einem Dateneingang D1 des ersten Zwischenspeichers FF1, ein Ausgang P2 der zweiten Stufe des Phasenschiebers PS mit einem Dateneingang D2 des zweiten Zwischenspeichers FF2 und parallel dazu mit einem Dateneingang DM des vierten Zwischenspeichers FFM verbunden. Ein Ausgang P3 der dritten Stufe des Phasenschiebers PS ist mit einem Dateneingang D3 des dritten Zwischenspeichers FF3 verbunden.

Ein Datenausgang Q2 des zweiten Zwischenspeichers FF2, der gleichzeitig auch den Datenausgang der Entscheidungslogik EL bildet, ist an einen Dateneingang DB des fünften Zwischenspeichers FFB angeschlossen. Weiterhin ist ein Datenausgang Q1, Q2, Q3, QM, QB jedes Zwischenspeichers FF1, FF2, FF3, FFM, FFB mit der Dekodiereinheit DE der Auswerteeinheit AWE verbunden (vgl. Figur 1). Jeder Zwischenspeicher FF1, FF2, FF3, FFM, FFB ist über einen Takteingang T1, T2, T3, TM, TB parallel an die Taktleitung TL angeschlossen, wobei der vierte Zwischenspeicher FFM einen invertierenden Takteingang TM aufweist. Die getakteten Zwischenspeicher werden durch sogenannte D-Flip-Flops realisiert.

In einer ersten Realisierung des Phasenschiebers PS, wie in Figur 2 gezeigt, werden drei Laufzeitglieder LZG1, LZG2, LZG3 verwendet, die von dem ankommenden digitalen Signal parallel durchlaufen werden. Die kleinste Phasendifferenz wird dabei durch die kleinste Laufzeitdifferenz zweier Laufzeitglieder bestimmt. Unabhängig von Laufzeittoleranzen muß somit immer die Phasenverschiebung $\phi 1$ durch das erste Laufzeitglied LZG1 kleiner als die Phasenverschiebung durch das zweite Laufzeitglied LZG2 und diese wieder kleiner als die Phasenverschiebung durch das dritte Laufzeitglied LZG3 sein. Die Laufzeitglieder können durch Leitungen einer gewissen Länge, durch ein Schieberegister oder aber durch einfache Logikgatter realisiert werden. In einer zweiten Realisierung des Phasenschiebers PS gemäß einer weiteren erfindungsgemäßen Ausgestaltung (nicht weiter gezeigt), sind zwei Laufzeitglieder LZG1, LZG2 in Reihe geschaltet. Ein vor dem ersten Laufzeitglied LZG1 angeordneter Abgriff bildet den Ausgang P1 der ersten Stufe, ein zwischen dem ersten LZG1 und dem zweiten Laufzeitglied LZG2 angeordneter Abgriff bildet den Ausgang P2 der zweiten Stufe und ein nach dem zweiten Laufzeitglied LZG2 angeordneter Abgriff bildet den Ausgang P3 der dritten Stufe des Phasenschiebers PS. Da das ankommende digitale Signal die drei Stufen seriell durchläuft, ist stets $\phi 1 < \phi 2 < \phi 3$ gegeben. Hier ist die kleinste Phasendifferenz $\Delta\phi = \phi 2 - \phi 1$ oder $\phi 3 - \phi 2$ durch die minimal realisierbare Laufzeit der Laufzeitglieder LZG1, LZG2 bestimmt.

Das ankommende digitale Signal wird über die steuerbare Verzögerungsleitung VZL zur Entscheidungslogik EL übertragen. Hier durchläuft es den dreistufigen Phasenschieber PS und wird durch den ersten, zweiten, dritten und vierten Zwischenspeicher FF1, FF2, FF3, FFM abgetastet und abgespeichert. Das Einlesen erfolgt mit der aktiven Flanke des Systemtaktes CK, wobei durch den invertierenden Takteingang TM des vierten Zwischenspeichers FFM, dieser eine halbe Systemtaktperiode T/2 früher und zwar mit der passiven Flanke den anliegenden Signalwert übernimmt.

Da der Dateneingang DB des fünften Zwischenspeichers FFB mit dem Datenausgang Q2 des zweiten Zwischenspeichers FF2 verbunden ist, übernimmt der fünfte Zwischenspeicher FFB mit jeder aktiven Systemtaktflanke den eine Systemtaktperiode T vorher abgetasteten Signalwert.

Die fünf Zwischenspeicher FF1, FF2, FF3, FFM, FFB liefern mit der aktiven Systemtaktflanke an ihren Datenausgängen Q1, Q2, Q3, QM, QB somit fünf Signale, die dem Datensignal zu den Zeiten $t+\Delta t$, t, $t-\Delta t$, t-T/2, t-T, entsprechen, wobei am Datenausgang Q2 des zweiten Zwischenspeichers FF2 das regenerierte Datensignal abgreifbar ist. Der Wert $\Delta t$ ergibt sich entsprechend aus der Verzögerung der Laufzeitglieder LZG1, LZG2, LZG3 des Phasenschiebers PS und mit T ist die Systemtaktperiode angegeben.

Diese fünf Datensignale liegen nun an der Dekodiereinheit DEC der Auswerteeinheit AWE an und werden entsprechend der nachstehenden Wahrheitstabelle der Dekodiereinheit DEC - Tabelle 1 - dekodiert.

| Q1 | Q2 | Q3 | QM | QB | U | D | O | F1 | F2 | QR |
|----|----|----|----|----|----|----|----|----|----|----|
| x | 0 | 1 | x | x | 1 | DO | DO | F10 | F20 | 0 |
| x | 1 | 0 | x | x | 1 | DO | DO | F10 | F20 | 0 |
| 0 | 1 | x | x | x | UO | 1 | DO | F10 | F20 | 0 |
| 1 | 0 | x | x | x | UO | 1 | DO | F10 | F20 | 0 |
| 0 | 0 | 0 | x | 1 | UO | DO | DO | F10 | 1 | 0 |
| 1 | 1 | 1 | x | 0 | UO | DO | OO | 1 | F20 | 0 |
| 0 | 0 | 0 | 1 | 0 | UO | DO | 1 | F10 | F20 | 0 |
| 1 | 1 | 1 | 0 | 1 | UO | DO | 1 | F10 | F20 | 0 |
| x | x | x | x | x | 0 | 0 | 0 | 0 | 0 | 1 |

Tabelle 1: Wahrheitstabelle Dekodiereinheit DEC und Rücksetzfunktion QR

Für den Fall, daß die an den Datenausgängen Q1, Q2 und Q3 der ersten drei Zwischenspeicher FF1, FF2, FF3 anliegende Signale unterschiedliche Polaritäten aufweisen - siehe obere Tabellenhälfte - wird entweder die erste Zustandsleitung U oder die zweite Zustandsleitung D mit einem logischen "Eins"-Pegel beaufschlagt, wobei die logischen Zustände der anderen Zustandsleitungen ihren bisherigen Wert beibehalten. Dabei bedeutet eine Belegung der ersten Zustandsleitung U, daß das ankommende digitale Signal in Bezug zum Systemtakt CK eine Verzögerung und eine Belegung der zweiten Zustandsleitung D, daß das ankommende digitale Signal eine Beschleunigung erfahren muß, um jeweils synchron mit dem Systemtakt CK zu sein.

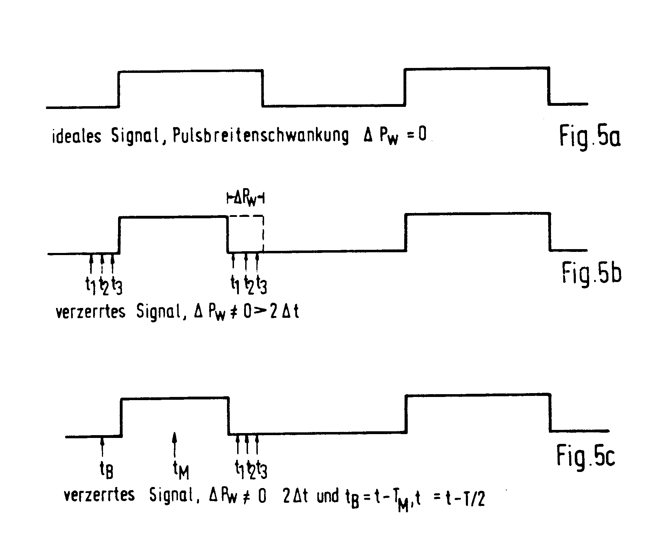

Falls nun zu den Zeiten $t_1 = t - \Delta t$, $t_2 = t$, $t_3 = t + \Delta t$, d.h. an den Datenausgängen Q1, Q2, Q3 jeweils das gleiche Bit anliegt, kann unter der Voraussetzung einer konstanten Pulsbreite mit Sicherheit angenommen werden, daß im zweiten Zwischenspeicher FF2 eine richtige Regeneration und Synchronisation erfolgt. Dies ist in Figur 5 dargestellt, in der unter a) ein ideales Signal ohne Pulsbreitenschwankung $\Delta$Pw gezeigt ist. Unterstellt man nun ein verzerrtes Signal nach Darstellung b), so wird bei einer angenommenen Pulsbreitenschwankung $\Delta$Pw > 2$\Delta$t zwar zu den Zeitpunkten $t_1$, $t_2$, $t_3$ jeweils der gleiche Signalzustand abgetastet, trotzdem ist der Abtastzeitpunkt "falsch" gewählt. Im Vergleich zu Darstellung a),wo keine Pulsbreitenschwankung vorliegt, wird der "falsche" Abtastzeitpunkt aufgrund der Pulsbreitenschwankung nicht erkannt.

Erfindungsgemäß wird nun auch ein verzerrtes Signal mit unterschiedlichen (High-Low) Pulsbreiten richtig ausgewertet, wie aus der unteren Hälfte der Tabelle 1 ersichtlich, in dem zusätzlich zu den Zeiten $t_1$, $t_2$, $t_3$ noch eine halbe Systemtaktperiode T/2 früher - Zeipunkt $t_M$ - und eine ganze Systemtaktperiode T früher - Zeitpunkt $t_B$ - das digitale Signal abgetastet wird. Dabei entspricht das Signal am Ausgang QM des vierten Zwischenspeichers FFM dem Abtastwert zum Zeitpunkt $t_M$ und das Signal am Ausgang QB des fünften Zwischenspeicher FFB dem Abtastwert zum Zeitpunkt $t_B$. Wird zum Zeitpunkt $t_B$ in Bezug zu den Zeitpunkten $t_1$, $t_2$, $t_3$ eine steigende Flanke detektiert, so wird die vierte Zustandsleitung F1 mit einem logischen "Eins"-Pegel beaufschlagt und entsprechend einer detektierten fallenden Flanke wird die fünfte Zustandsleitung F2 mit einem logischen "Eins"-Pegel belegt.

Sollte der Abtastwert zum Zeitpunkt $t_B$ mit den Abtast werten zu den Zeiten $t_1$, $t_2$, $t_3$ übereinstimmen und der Abtastwert zum Zeitpunkt $t_M$ eine andere Polarität aufweisen, so wird die dritte Zustandsleitung O mit einem logischen "Eins"-Pegel belegt. Somit wird, wie in Figur 5 Darstellung c) gezeigt, durch die zusätzlichen Signalzustände zu den Zeitpunkten $t_B$ und $t_M$ ein möglicher falscher Abtastzeitpunkt aufgrund unterschiedlicher Pulsbreiten des Signales erkannt.

Der in Tabelle 1 aufgezeigte Wert QR wird später noch erläutert.

Die durch die Dekodiereinheit DEC dekodierten Systemtakt-Daten-Phasenbeziehungen werden über die fünf Zustandsleitungen U, D, O, F1, F2 zum Entscheider ENT übertragen, der zusätzlich das Vorliegen einer Minimalverzögerung oder einer Maximalverzögerung der Verzögerungsleitung VZL auswertet, wozu er über die erste Leitung BU bzw. über die zweite Leitung BD mit der steuerbaren Verzögerungsleitung VZL verbunden ist.

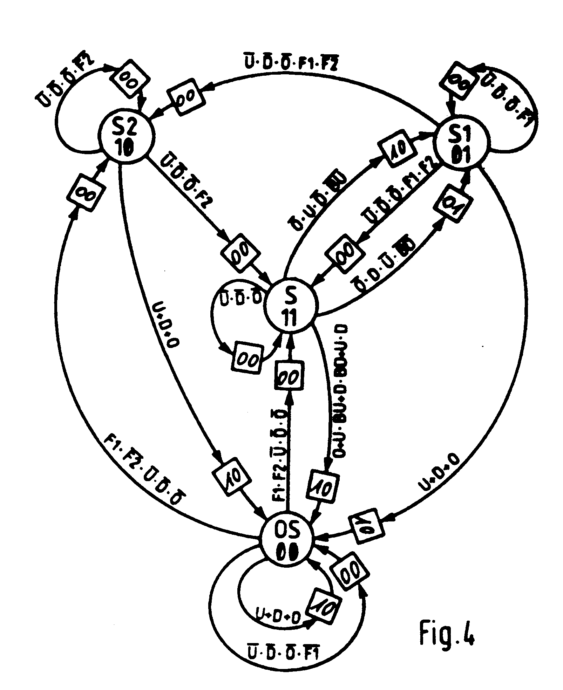

Gemäß dem in Figur 4 gezeigten Zustandsdiagramm des Entscheiders ENT sind vier Zustände zu unterscheiden, die der folgenden Tabelle zu entnehmen sind.

| Zustand | | | Bedeutung |
|---------|----|----|-----------|
| Symbol | Z1 | Z0 | |
| S | 1 | 1 | Systemtakt-Daten-Phasenbeziehung richtig |
| S2 | 1 | 0 | VZL wurde justiert, Phasenbez. bzgl. steigender Flanke richtig bzgl. fallender Flanke noch nicht detektiert |
| S1 | 0 | 1 | VZL um 1 geändert |
| OS | 0 | 0 | Systemtakt-Daten-Phasenbeziehung falsch. |

Tabelle 2: Zustände des Entscheiders

Die vier Zustände S, S2, S1, OS des Entscheiders ENT sind an dem ersten Zustandsanzeigeausgang Z0 und an den zweiten Zustandsanzeigeausgang Z1 jederzeit entnehmbar und können zur weiteren Überwachung, Testung oder Auswertung der erfindungsgemäßen Schaltungsanordnung auf eine entsprechende externe Einheit geleitet werden.

Entsprechend der im folgenden gezeigten Tabelle 3 wird durch den Entscheider ENT in Abhängigkeit der anliegenden Eingangsvariablen, die über die fünf Zustandsleitungen U, D, O, F1, F2, sowie über die erste Leitung BU und die zweite Leitung BD anliegen, ein Steuersignal über die erste Steuerleitung UPO oder die zweite Steuerleitung DOWNO zur Verzögerungsregeleinheit VRE gesendet.

EP 0 225 587 B1

| Lfd. Nr. | Entscheider | | | | UPO | DOWNO |
|---|---|---|---|---|---|---|
| | Start-Zustand | Eingangsvariable | Ziel-Zustand | | | |
| 1 | (00) OS | $U+D+O$ | (00) OS | | 1 | 0 |
| 2 | (00) OS | $\overline{U}\cdot\overline{D}\cdot\overline{O}\cdot\overline{F1}$ | (00) OS | | 0 | 0 |
| 3 | (00) OS | $\overline{U}\cdot\overline{D}\cdot\overline{O}\cdot F1\cdot\overline{F2}$ | (10) S2 | | 0 | 0 |
| 4 | (00) OS | $\overline{U}\cdot\overline{D}\cdot\overline{O}\cdot F1\cdot F2$ | (11) S | | 0 | 0 |
| 5 | (01) S1 | $U+D+O$ | (00) OS | | 1 | 0 |
| 6 | (01) S1 | $\overline{U}\cdot\overline{D}\cdot\overline{O}\cdot\overline{F1}$ | (01) S1 | | 0 | 0 |
| 7 | (01) S1 | $\overline{U}\cdot\overline{D}\cdot\overline{O}\cdot F1\cdot\overline{F2}$ | (10) S2 | | 0 | 0 |
| 8 | (01) S1 | $\overline{U}\cdot\overline{D}\cdot\overline{O}\cdot F1\cdot F2$ | (11) S | | 0 | 0 |
| 9 | (10) S2 | $U+D+O$ | (00) OS | | 1 | 0 |
| 10 | (10) S2 | $\overline{U}\cdot\overline{D}\cdot\overline{O}\cdot\overline{F2}$ | (10) S2 | | 0 | 0 |
| 11 | (10) S2 | $\overline{U}\cdot\overline{D}\cdot\overline{O}\cdot F2$ | (11) S | | 0 | 0 |
| 12 | (11) S | $\overline{U}\cdot\overline{D}\cdot\overline{O}$ | (11) S | | 0 | 0 |
| 13 | (11) S | $U\cdot\overline{D}\cdot\overline{BU}\cdot\overline{O}$ | (01) S1 | | 1 | 0 |
| 14 | (11) S | $D\cdot\overline{U}\cdot\overline{BD}\cdot\overline{O}$ | (01) S1 | | 0 | 1 |
| 15 | (11) S | $O+U\cdot BU+D\cdot BD+U\cdot D$ | (00) OS | | 1 | 0 |

Tabelle 3: Entscheidungstabelle des Entscheiders

Aufgrund einer detektierten falschen Systemtakt-Daten-Phasenbeziehung, z.B. gemäß der laufenden Nummer 1 in der Tabelle 3, wird über die erste Steuerleitung UPO ein Zählimpuls auf den Eingang VE für die Vorwärtszählrichtung des Vorwärts-Rückwärts-Zählers VRZ gegeben. Nach Abgabe eines Zählimpulses über die erste Steuerleitung UPO werden durch den Entscheider ENT über eine auf die Dekodiereinheit DEC zurückgekoppelten Rücksetzleitung QR - vgl. Tabelle 1 linke Spalte - für die Dauer einer Taktperiode des internen Taktes TI die Dekodiereinheit DEC zurückgesetzt, um eine sichere Ausführung des Zählimpulses zu gewährleisten.

Durch den Zählimpuls wird der Zählerstand des Vorwärts-Rückwärts- Zählers VRZ um Eins erhöht, wodurch sich eine Verzögerung der ankommenden digitalen Signale in Bezug auf den Systemtakt CK wie folgt ergibt.

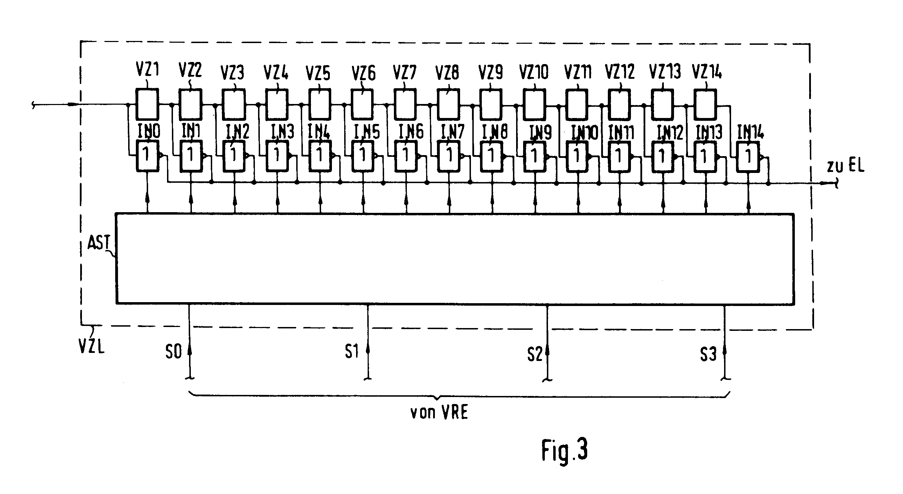

Dazu wird zunächst eine Realisierungsmöglichkeit der steuerbaren Verzögerungsleitung VZL gemäß Figur 3 beschrieben. Figur 3 zeigt eine aus vierzehn in Reihe geschalteten Verzögerungsgliedern VZ1, VZ2, ..., VZ14 aufgebaute Verzögerungsleitung VZL, wobei der O-te bis zu dem 14-ten Abgriff jeweils über einen ansteuerbaren Inverter IN0, IN1, ..., IN14 auf den Datenausgang der steuerbaren Verzögerungsleitung VZL geführt ist.

Zum Steuern der Verzögerungsleitung VZL ist eine Ansteuereinheit AST einerseits an die steuerbaren Inverter IN0, IN1, ..., IN14 und andererseits über die Adressenleitungen S0, S1, S2, S3 an die Ausgänge A0, A1, A2, A3 des Vorwärts-Rückwärts-ZählersVRZ angeschlossen.

Ist nun z.B. der Vorwärts-Rückwärts-Zähler VRZ über den voreinstellbaren Eingang PR auf den Zählerstand 7 eingestellt, so wird dieser Wert über die Adressenleitungen S0, S1, S2, S3 zur Ansteuereinheit AST übertragen, die genau den siebten Inverter IN7 durchsteuert, wobei gleichzeitig alle anderen Inverter für die Datenübertragung gesperrt sind. Das digitale Signal durchläuft also zunächst die ersten sieben Verzögerungsglieder VZ1, ..., VZ7, den siebten Inverter IN7 und gelangt über den Datenausgang der steuerbaren Verzögerungsleitung VZL zur Entscheidungslogik EL.

Wird nun, wie zuvor beschrieben, durch einen Zählimpuls über die erste Steuerleitung UPO der Zählerstand um Eins auf den Wert acht erhöht, so wird dies über die Adressenleitungen S0, S1, S2, S3 an

6

die Ansteuereinheit AST weitergeleitet. Dadurch wird jetzt der achte Inverter IN8 durchgeschaltet, d.h alle anderen Inverter inklusive dem siebten Inverter IN7 sind gesperrt. Das digitale Signal wird nun um die Zeit eines weiteren Verzögerungsgliedes verzögert.

Entsprechend wird ein Zählimpuls über die zweite Steuerleitung DOWNO durch den Entscheider ENT auf den Eingang RE des Vorwärts-Rückwärts-Zählers VRZ gegeben, wenn, wie z.B. gemäß der laufenden Nummer 14 in Tabelle 3,eine Beschleunigung des digitalen Signales erfolgen muß.

Aufgrund eines gesendeten logischen "0"-Zustandes, über die erste UPO und die zweite Steuerleitung DOWNO, wie z.B. gemäß der laufenden Nummer 2 in Tabelle 3, wird keine Verzögerungszeitänderung der steuerbaren Verzögerungsleitung VZL hervorgerufen.

Außerdem ist ein gleichzeitiges Anlegen eines eine Verzögetung und eine Beschleunigung bewirkenden Zählimpulses über die Steuerleitungen UPO, DOWNO - wie Tabelle 3 zu entnehmen ist - nicht möglich.

Das Auswerten einer Minimal- oder einer Maximalverzögerung der Verzögerungsleitung durch den Entscheider ENT verhindert ein mögliches Schwingen der Verzögerungsleitung VZL zwischen einer maximalen Verzögerung (vierzehnter Inverter IN14 durchgeschaltet) und einer minimalen Verzögerung (nullter Inverter INO durchgeschaltet, d.h. kein Verzögerungsglied aktiviert).

Die erfindungsgemäße Schaltungsanordnung arbeitet bei beliebigen Bitraten (typisch: 140 MBit/s) bis zu einer maximalen Bitrate mit einer minimalen Bitlänge von $T_{min}$, die durch die zeitliche Auflösung der Abtastschaltung AS (Laufzeit bzw. Laufzeitdifferenz $\Delta t$ der Laufzeitglieder LZG1, LZG2, LZG3), durch die zeitliche Auflösung der Verzögerungsleitung $t_{VZL}$ , durch die Abweichung $\Delta Pw$ der Pulsbreite von der Bitlänge $T_{min}$ und durch die Flankensteilheit $t_{RF}$ gemäß der Beziehung

$$T_{min} > t_{VZL} + 2\Delta t + \Delta Pw + t_{RF}$$

bestimmt wird.

## Patentansprüche

1.  Schaltungsanordnung zum Regenerieren und Synchronisieren eines digitalen Signals hoher Bitrate, die eine Reihenschaltung aus einer steuerbaren Verzögerungsleitung (VZL) und einer Entscheidungslogik (EL) aufweist, welche von dem digitalen Signal durchlaufen wird, wobei die Entscheidungslogik (EL) über eine erste Steuerleitung (UPO) und eine zweite Steuerleitung (DOWNO) und die steuerbare Verzögerungsleitung (VZL) über Adressenleitungen (S0, S1, S2, S3) an eine Verzögerungsregeleinheit (VRE) angeschlossen ist, wobei die Entscheidungslogik (EL) über eine Taktleitung (TL) mit einem Systemtakt (CK) versorgt wird, dessen Frequenz der Bitrate des zu regenerierenden digitalen Signales entspricht und wobei die Verzögerungsregeleinheit(VRE) einen voreinstellbaren Eingang (PR) zum Setzen eines vorgebbaren Zustandes aufweist,
    **dadurch gekennzeichnet,** daß die Entscheidungslogik (EL) eine an die Taktleitung (TL) angeschlossene Abtastschaltung (AS) und eine Auswerteeinheit (AWE) aufweist, durch die das digitale Signal in wenigstens drei aufeinanderfolgenden Abtastzeitpunkten t - $\Delta t$, t, t + $\Delta t$, mit $\Delta t$ = Abtastintervall und zusätzlich in den Zeitpunkten t - T/2 und t - T, mit T = Systemtaktperiode, abgetastet wird und anschließend ausgewertet wird, ob aufgrund der wenigstens drei aufeinanderfolgenden Abtastzeitpunkten eine richtige Systemtakt-Daten-Phasenbeziehung vorliegt und ob, aufgrund der zusätzlichen Zeitpunkte, ein möglicher falscher Abtastzeitpunkt wegen unterschiedlicher Pulsbreiten des Signals vorliegt, daß die Auswerteeinheit (AWE) einen ersten Zustandsanzeigeausgang (Z0) und einen zweiten Zustandsanzeigeausgang (Z1) enthält und daß die steuerbare Verzögerungsleitung (VZL) über eine erste Leitung (BU) und eine zweite Leitung (BD) an die Auswerteeinheit (AWE) angeschlossen ist, über die das Vorliegen einer Minimalverzögerung bzw. einer Maximalverzögerung der Verzögerungsleitung (VZL) zur Auswerteeinheit (AWE) übermittelt wird.

2.  Schaltungsanordnung nach Anspruch 1, dadurch gekennzeichnet daß die Abtastschaltung (AS) einen dreistufigen Phasenschieber (PS) und eine aus fünf Zwischenspeicher (FF1, FF2, FF3, FFM, FFB) aufgebaute Abtast/Speichereinheit (ASPE) enthält, daß ein Ausgang (P1) der ersten Stufe des Phasenschiebers (PS) mit einem Dateneingang (D1) des ersten Zwischenspeichers (FF1), daß ein Ausgang (P2) der zweiten Stufe des Phasenschiebers (PS) mit einem Dateneingang (D2) des zweiten Zwischenspeichers (FF2) und mit einem Dateneingang (DM) des vierten Zwischenspeichers (FFM) und daß ein Ausgang (P3) der dritten Stufe des Phasenschiebers (PS) mit einem Dateneingang (D3) des dritten Zwischenspeichers (FF3) verbunden sind, daß ein Datenausgang (Q2) des zweiten Zwischenspeichers (FF2), der den Datenausgang der Entscheidungslogik (EL) bildet, an einen Dateneingang (DB) des fünften Zwischenspeichers (FFB) angeschlossen ist, daß ein Datenausgang (Q1, Q2, Q3, QM, QB) jedes Zwischenspeichers (FF1, FF2, FF3, FFM, FFB) mit der Auswerteeinheit (AWE) verbunden ist und daß jeder Zwischenspeicher (FF1, FF2, FF3, FFM, FFB) einen parallel an die Taktleitung (TL) angeschlossenen Takteingang (T1, T2, T3, TM, TB) aufweist, wobei der vierte Zwischenspeicher (FFM) einen invertierenden Takteingang (TM) enthält.

3.  Schaltungsanordnung nach Anspruch 2, dadurch gekennzeichnet, daß die Auswerteeinheit (AWE) eine Dekodierheit (DEC) und einen Entscheider (ENT) aufweist, daß die Dekodiereinheit (DEC) einerseits mit den Datenausgängen (Q1, Q2, Q3, QM, QB) der Zwischenspeicher (FF1, FF2, FF3, FFM, FFB) der Abtast/Speichereinheit (ASPE) und andererseits zum Weiterleiten der dekodierten Signalzustände über fünf Zustandsleitungen (U, D, O, F1, F2) mit dem Entscheider (ENT) verbunden ist und daß der Entscheider (ENT) über die erste (UPO) und die zweite Steuerleitung (DOWNO) mit der Verzögerungsregeleinheit (VRE) und über die erste (BU) und die zweite Leitung (BD) mit der steuerbaren Verzögerungsleitung (VZL) verbunden ist, so daß die jeweilige Signal-Systemtakt-Phasenbeziehung an dem ersten (Z0) und dem zweiten Zustandsanzeigeausgang (Z1) des Entscheiders (ENT) abgreifbar ist.

4.  Schaltungsanordnung nach Anspruch 3, dadurch gekennzeichnet, daß der Entscheider (ENT) und die Verzögerungsregeleinheit (VRE) mit einem internen, von dem Systemtakt (TK) abgeleiteten Takt (TI) versorgt werden und daß der Entscheider (ENT) über eine Rücksetzleitung (QR) auf die Dekodiereinheit (DEC) zurückgekoppelt ist, so daß bei Abgabe eines Steuersignales über die erste (UPO) oder zweite Steuerleitung (DOWNO) die Dekodiereinheit (DEC) für die Dauer einer Taktperiode des internen Taktes (TI) zurückgesetzt wird.

5.  Schaltungsanordnung nach Anspruch 2, dadurch gekennzeichnet, daß die drei Stufen des Phasenschiebers (PS) durch Laufzeitglieder (LZG1, LZG2, LZG3) gebildet werden, die von dem ankommenden digitalen Signal parallel durchlaufen werden, wobei die Phasenverschiebung durch das erste Laufzeitglied (LZG1) kleiner als die Phasenverschiebung durch das zweite Laufzeitglied (LZG2) ist und wobei die Phasenverschiebung durch das zweite Laufzeitglied (LZG2) kleiner als die Phasenverschiebung durch das dritte Laufzeitglied (LZG3) ist.

6.  Schaltungsanordnung nach Anspruch 2, dadurch gekennzeichnet, daß der Phasenschieber (PS) zwei in Reihe geschaltete Laufzeitglieder (LZG1, LZG2) aufweist, wobei ein vor dem ersten Laufzeitglied (LZG1) angeordneter Abgriff den Ausgang (P1) der ersten Stufe, ein zwischen das erste Laufzeitglied (LZG1) und das zweite Laufzeitglied (LZG2) angeordneter Abgriff den Ausgang (P2) der zweiten Stufe und ein nach dem zweiten Laufzeitglied (LZG2) angeordneter Abgriff den Ausgang (P3) der dritten Stufe des Phasenschiebers (PS) bildet, so daß das ankommende digitale Signal die drei Stufen nacheinander durchläuft.

7.  Schaltungsanordnung nach Anspruch 3, dadurch gekennzeichnet, daß die Verzögerungsregeleinheit (VRE) einen synchronen mit dem internen Takt (TI) verbundenen Vorwärts-Rückwärts-Zähler (VRZ) mit dem voreinstellbaren Eingang (PR) aufweist, daß die erste Steuerleitung (UPO) und die zweite Steuerleitung (DOWNO) an einen Eingang für die Vorwärtszählrichtung (VE) bzw. an einen Eingang für die Rückwärtszählrichtung (RE) des Vorwärts-Rückwärts-Zählers (VRZ) angeschlossen sind und daß die steuerbare Verzögerungsleitung (VZL) über die Adressenleitungen (S0, S1, S2, S3) mit Ausgängen (A0, A1, A2, A3) des Vorwärts-Rückwärts-Zählers (VRZ) verbunden ist.

**Claims**

1.  A circuit arrangement for regenerating and synchronizing a digital signal of high bit rate comprising a series combination of a variable delay line (VZL) and a decision logic (EL) through which the digital signal passes, with the decision logic (EL) connected to a delay control unit (VRE) by a first control line (UPO) and a second control line (DOWNO), and the variable delay line (VZL) connected to the delay control unit (VRE) by address lines (S0, S1, S2, S3), the decision logic (EL) being supplied via a clock line (TL) with a system clock (CK) having a frequency equal to the bit rate of the digital signal to be regenerated, and the delay control unit (VRE) having a preset input (TR) for establishing a presettable condition,
    **characterized in** that the decision logic (EL) contains a sampling circuit (AS), which is connected to the clock line (TL), and an evaluating facility (AWE) by which the digital signal is sampled at at least three successive sampling instants t - Δt, t, t + Δt, where Δt = sampling interval, and additionally at the instants t - T/2 and t - T, where T = system clock period, and subsequently determines on the basis of the at least three successive sampling instants whether a correct system-clock/data phase relationship exists, and on the basis of the additional instants whether there is any false sampling instant due to differing pulse widths of the signal, that the evaluating facility (AWE) has a first state-indicating output (Z0) and a second state-indicating output (Z1), and that the variable delay line (VZL) is connected to the evaluating facility (AWE) by a first line (BU) and a second line (BD) over which the presence of, respectively, a minimum delay and a maximum delay of the delay line (VZL) is communicated to the evaluating facility (AWE).

2. A circuit arrangement as claimed in claim 1, characterized in that the sampling circuit (AS) contains a three-stage phase shifter (PS) and a sample/hold unit (ASPE) consisting of five latches (FF1, FF2, FF3, FFM, FFB), that an output (P1) of the first stage of the phase shifter (PS) is connected to a data input (D1) of the first latch (FF1), that an output (P2) of the second stage of the phase shifter (PS) is connected to a data input (D2) of the second latch (FF2) and to a data input (DM) of the fourth latch (FFM), that an output (P3) of the third stage of the phase shifter (PS) is connected to a data input (D3) of the third latch (FF3), that a data output (Q2) of the second latch (FF2), which forms the data output of the decision logic (EL), is connected to a data input (DB) of the fifth latch (FFB), that a data output (Q1, Q2, Q3, QM, QB) of each of the latches (FF1, FF2, FF3, FFM, FFB) is connected to the evaluating facility (AWE), and that each of the latches (FF1, FF2, FF3, FFM, FFB) has a clock input (T1, T2, T3, TM, TB) connected to the clock line (TL) in parallel, with the clock input (TM) of the fourth latch (FFM) being an inverting input.

3. A circuit arrangement as claimed in claim 2, characterized in that the evaluating facility (AWE) contains a decoder unit (DEC) and a decision unit (ENT), that the decoder unit (DEC) has one end connected to the data outputs (Q1, Q2, Q3, QM, QB) of the latches (FF1, FF2, FF3, FFM, FFB) of the sample/hold unit (ASPE), that the other end of the decoder unit (DEC) is connected to the decision unit (ENT) by five state lines (U, D, O, F1, F2) for transferring the decoded signal states, and that the decision unit (ENT) is connected to the delay control unit (VRE) by the first control line (UPO) and the second control line (DOWNO), and to the variable delay line (VZL) by the first line (BU) and the second line (BD), so that the respective phase relationship between the signal and the system clock can be obtained from the first state-indicating output (Z0) and the second state-indicating output (Z1) of the decision unit (ENT).

4. A circuit arrangement as claimed in claim 3, characterized in that the decision unit (ENT) and the delay control unit (VRE) are supplied with an internal clock (TI) derived from the system clock (TK), and that the decision unit (ENT) is coupled to the decoder unit (DEC) via a preset line (QR), so that, when a control signal is sent out over the first (UPO) or second control line (DOWNO), the decoder unit (DEC) is reset for one period of the internal clock (TI).

5. A circuit arrangement as claimed in claim 2, characterized in that the three stages of the phase shifter (PS) are implemented with delay elements (LZG1, LZG2, LZG3) through which the incoming digital signal passes in parallel, with the phase shift produced by the first delay element (LZG1) being smaller than the phase shift produced by the second delay element (LZG2), and with the phase shift produced by the second delay element (LZG2) being smaller than the phase shift produced by the third delay element (LZG3).

6. A circuit arrangement as claimed in claim 2, characterized in that the phase shifter (PS) comprises two delay elements (LZG1, LZG2) in series, with a tap ahead of the first delay element (LZG1) forming the output (P1) of the first stage of the phase shifter (PS), a tap between the first delay element (LZG1) and the second delay element (LZG2) forming the output (P2) of the second stage, and a tap behind the second delay element (LZG2) forming the output (P3) of the third stage, so that the incoming digital signal passes through the three stages in succession.

7. A circuit arrangement as claimed in claim 3, characterized in that the delay control unit (VRE) comprises a synchronous up/down counter (VRZ) connected to the internal clock (TI) and having the preset input (PR), that the first control line (UPO) and the second control line (DOWNO) are connected, respectively, to an up input (VE) and a down input (RE) of the up/down counter (VRZ), and that the variable delay line (VZL) is connected to the outputs (A0, A1, A2, A3) of the up/down counter (VRZ) via the address lines (S0, S1, S2, S3).

**Revendications**

1. Agencement de circuit pour la régénération et la synchronisation d'un signal numérique à débit binaire élevé comprenant un circuit série, qui comporte une ligne à retard réglable (VZL) et une logique de décision (EL), parcourue par le signal numérique, la logique de décision (EL) étant raccordée via une première ligne de commande (UPO) et une deuxième ligne de commande (DOWNO) et la ligne à retard réglable (VZL) étant raccordée par des lignes d'adresse (S0, S1, S2, S3) à une unité de commande de retard (VRE), la logique de décision (EL) recevant un rythme de système (CK) via une ligne de cadencement (TI) et donc la fréquence correspond au débit binaire du signal numérique à régénérer et dans lequel l'unité de commande du retard (VRE) est munie d'une entrée pré-réglable (PR) pour la détermination d'un état prédéterminé, caractérisé en ce que la logique de décision (EL) est munie d'un circuit d'échantillonnage (AS) raccordé à la ligne de cadencement (TL) et d'une unité d'analyse (AWE), au moyen desquels le signal numérique est échantillonné pendant au moins trois points séquentiels d'échantillonnage t - $\Delta$t, t, t + $\Delta$t, où $\Delta$t = intervalle d'échantillonnage, et en plus, à des instants temporels t - T/2 et t - T où T = période du rythme système, en étant ensuite analysé, pour la présence d'un bon rapport de phase rythme système/données sur la base des au moins trois intervalles séquentiels d'échantillonnage et pour savoir, en utilisant les instants d'échantillonnage supplémentaires, si un éventuel mauvais instant d'échantillonnage est présent à cause de différentes largeurs d'impulsion du signal, en ce que l'unité d'analyse (AWE) est munie d'une première sortie d'indication d'état (Z0) et d'une deuxième sortie d'indication d'état (Z1) et en ce que la ligne à retard réglable (VZL) est raccordée à l'unité d'analyse (AWE) au moyen d'une première ligne (BU) et d'une deuxième ligne (BD) permettant de transmettre la présence d'un retard minimal ou, respectivement, un retard maximal sur la ligne à retard (VZL) vers l'unité d'analyse (AWE).

2. Agencement de circuit selon la revendication 1, caractérisé en ce que le circuit d'échantillonnage (AS) comporte un circuit de décalage de phase (PS) à trois étages et une unité d'échantillonnage/stockage (ASTE) composée de cinq mémoires intermédiaires (FF1, FF2, FF3, FFM, FFB), en ce qu'une sortie (P1) du premier étage du circuit de décalage de phase (TS) est reliée à une première entrée de données (T1) de la première mémoire intermédiaire (FF1), en ce qu'une sortie (P2) du deuxième étage du circuit de décalage de phase (PS) est raccordée à une entrée de données (PS) de la deuxième mémoire intermédiaire (FF2) et à une entrée de données (DM) de la quatrième mémoire intermédiaire (FFM), et en ce qu'une sortie (P3) du troisième étage du circuit de décalage de phase (PS) est raccordée à une entrée de données (D3) de la troisième mémoire intermédiaire (FF3), en ce qu'une sortie de données (Q2) de la deuxième mémoire intermédiaire (FF2) qui constitue la sortie de données de la logique de décision (EL) est raccordée à une entrée de données (DB) de la cinquième mémoire intermédiaire (FFB), en ce qu'une sortie de données (Q1, Q2, Q3, QM, QB) de chaque mémoire intermédiaire (FF1, FF2, FF3, FFM, FFB) est raccordée à l'unité d'analyse (AWE) et en ce que chaque mémoire intermédiaire (FF1, FF2, FF3, FFM, FFB) est munie d'une entrée de cadencement (T1, T2, T3, TM, TB) raccordée en parallèle sur la ligne de cadencement (TL), la quatrième mémoire intermédiaire (FFM) étant munie d'une entrée inversante de cadencement (TM).

3. Agencement de circuit selon la revendication 2, caractérisé en ce que l'unité d'analyse (AWE) est munie d'une unité de décodage (DEC) et d'une unité de décision ENT, en ce que l'unité de décodage (DEC) est reliée, d'une part, aux sorties de données (Q1, Q2, Q3, QM, QB) des mémoires intermédiaires (FF1, FF2, FF3, FFM, FFB) de l'unité d'échantillonnage/stockage (ASTE) et, d'autre part, pour la retransmission des états décodés de signal, via cinq lignes d'état (U, D, O, F1, F2) à l'unité de décision (ENT), et en ce que l'unité de décision (ENT) et reliée via la première (UPO) et la deuxième (DOWNO) ligne de commande à l'unité de commande de retard (VRE) et via la première (BU) et la deuxième (BD) ligne à la ligne à retard réglable (VZL) de manière à ce que le rapport de phase signal/rythme système respectif peut être obtenu sur la première (Z0) et sur la deuxième (Z1) sortie d'indication d'état de l'unité de décision (ENT).

4. Agencement de circuit selon la revendication 3, caractérisé en ce que l'unité de décision (ENT) et l'unité de commande de retard (VRE) reçoivent un rythme interne (TI) qui est obtenu à partir du rythme système (TK) et en ce que l'unité de décision (ENT) est rebouclée, via une ligne de remise à zéro (QR) sur l'unité de décodage (DEC) de manière à ce que lors de l'émission d'un signal de commande via la première (UPO) ou la deuxième (DOWNO) ligne de commande, l'unité de décodage (DEC) est remise à zéro pour la durée d'une période du rythme interne (TI).

5. Agencement de circuit selon la revendication 2, caractérisé en ce les trois étages du circuit de décalage de phase (TS) sont constitués d'éléments de ligne à retard (LZG1, LZG2, LZG3) qui sont traversés en parallèles par le signal numérique dérivé, de manière à ce que le décalage de phase après passage par le premier élément de ligne à retard (LZG1) soit inférieur au décalage de phase après passage par le deuxième élément de ligne de retard (LZG2) et le décalage de phase après passage par le deuxième élément de ligne à retard (LZG2) soit inférieur au décalage de phase après passage par le troisième élément de ligne à retard (LZG3).

6. Agencement de circuit selon la revendication 2, caractérisé en ce que le circuit de décalage de phase (PS) comporte des éléments de ligne à retard (LZG1, LZG2) raccordés en série, un point de prélèvement situé avant le premier élément de ligne à retard (LZG1) constituant la sortie (P1) du premier étage, un point de prélèvement situé entre le premier élément de ligne à retard (LZG1) et le deuxième élément de ligne à retard (LZG2) constituant la sortie (P2) du deuxième étage et un point de prélèvement situé après le deuxième élément de ligne à retard (LZG2) constituant la sortie (P3) du troisième étage du circuit de décalage de phase (PS) de manière à ce que le signal numérique dérivé traverse les trois étages l'un après l'autre.

7. Agencement de circuit selon la revendication 3, caractérisé en ce que l'unité de commande de retard (VRE) est munie d'un compteur/décompteur (VRZ) accordé de manière synchrone au rythme interne et munie d'une entrée (PR) pré-réglable, en ce que la première ligne de commande (UPO) et la deuxième ligne de commande (DOWNO) sont raccordées à une entrée pour le centre de comptage avance (VE) et, respectivement, à une entrée pour le centre de comptage arrière (RE) du compteur/décompteur et en ce que la ligne à retard réglable (VZL) est reliée, via les lignes d'adresse (S0, S1, S2, S3) à des sorties (A0, A1, A2, A3) du compteur/décompteur (VRZ).

Fig.1

Fig.2

Fig. 3

14

Fig.4

ideales Signal, Pulsbreitenschwankung $\Delta P_W = 0$.

Fig.5a

$\vdash\Delta P_W\dashv$

$t_1\,t_2\,t_3$     $t_1\,t_2\,t_3$

verzerrtes Signal, $\Delta P_W \neq 0 > 2\,\Delta t$

Fig.5b

$t_B$    $t_M$    $t_1\,t_2\,t_3$

verzerrtes Signal, $\Delta P_W \neq 0$   $2\,\Delta t$ und $t_B = t - T_M, t = t - T/2$

Fig.5c